# EUROPÄISCHE PATENTANMELDUNG

(11) **EP 3 715 808 A1**
(43) Veröffentlichungstag der Anmeldung: **30.09.2020**
(21) Anmeldenummer: 20172290.7
(22) Anmeldetag: 28.05.2019
(51) Int. Cl.: G01L 1/14, G01N 27/22, G01D 5/24, H05K 1/16

(54) **VORRICHTUNG ZUR MESSUNG VON DRUCK UND/ODER FEUCHTIGKEIT**

(30) Priorität: 18.07.2018 DE 102018117349
(62) Teilanmeldung aus: 19727365.9
(71) Anmelder: B-Horizon GmbH, 93161 Sinzing (DE)
(72) Erfinder: Kabany, Mohammad, 93053 Regensburg (DE)
(74) Vertreter: Peters, Andreas

(57) **Zusammenfassung**

Die Erfindung betrifft eine Vorrichtung zur Messung von Druck und/oder Feuchtigkeit, sowie ein Verfahren zur Messung von Druck und/oder Feuchtigkeit. Die Vorrichtung umfasst zumindest einen Sensor zur Messung von Druck und/oder Feuchtigkeit, wobei der Sensor zumindest einen Kondensator mit zumindest zwei Elektroden umfasst, welche, insbesondere in einer horizontalen Richtung entlang eines und auf einem, insbesondere flexiblem, Trägermaterial zueinander angeordnet sind. Dabei ist zwischen den Elektroden zumindest eine dielektrische Schicht angeordnet. Die Erfindung ist dadurch gekennzeichnet, dass auf einer einem Trägermaterial abgewandten Seite zumindest eine Elektrode und/oder die dielektrische Schicht zumindest stellenweise, zumindest eine, zumindest teilweise flüssigkeitsdurchlässige und/oder flüssigkeitsabsorbierende Feuchteschicht angeordnet ist. Dabei sind somit die zumindest eine Elektrode und/oder die dielektrische Schicht in einer Querrichtung zwischen dem Trägermaterial und der Feuchteschicht angeordnet. So verändert sich eine Kapazität durch die auf die dielektrische Schicht zumindest teilweise treffende Flüssigkeit zumindest teilweise, wobei eine Verarbeitungseinheit dazu eingerichtet und dafür vorgesehen ist diese Änderung zu messen und/oder zu speichern, sodass ein kapazitiver Feuchtesensor entsteht.

## Beschreibung

Die vorliegende Erfindung betrifft eine Vorrichtung zur Messung von Druck und/oder Feuchtigkeit sowie ein Verfahren zur Messung von Druck und/oder Feuchtigkeit umfassend die jeweiligen Oberbegriffe der Patentansprüche 1 und 8.

Die erfindungsgemäße Vorrichtung zur Messung von Druck und/oder Feuchtigkeit umfasst zumindest einen Sensor zur Messung von Druck und/oder Feuchtigkeit, wobei der Sensor zumindest einen Kondensator mit zumindest zwei Elektroden umfasst, welche, insbesondere in einer horizontalen Richtung, entlang eines und auf einem, insbesondere flexiblen, Trägermaterial zueinander angeordnet sind, wobei zwischen den Elektroden zumindest eine dielektrische Schicht angeordnet ist.

Die horizontale Richtung ist vorzugsweise eine Haupterstreckungsrichtung des flexiblen Trägermaterials.

"Flexibel" heißt in diesem Zusammenhang, dass das Trägermaterial zumindest stellenweise biegsam und damit elastisch ist.

Insbesondere kann es sich bei dem Trägermaterial um einen Webstoff oder um einen sonstigen Bekleidungsstoff, wie zum Beispiel ein Polyester handeln.

Die dielektrische Schicht beabstandet damit die beiden Elektroden in einer horizontalen und/oder in einer dazu senkrechten Querrichtung.

Erfindungsgemäß ist auf einer dem Trägermaterial abgewandten Seite zumindest eine Elektrode und/oder der dielektrischen Schicht zumindest stellenweise, zumindest eine, zumindest teilweise flüssigkeitsdurchlässige und/oder flüssigkeitsabsorbierende Feuchteschicht angeordnet, wobei somit die zumindest eine Elektrode und/oder dielektrische Schicht in einer Querrichtung zwischen dem Trägermaterial und der Feuchteschicht angeordnet sind, sodass eine Kapazität durch die auf die dielektrische Schicht zumindest teilweise treffende Flüssigkeit, zumindest teilweise verändert, wobei eine Verarbeitungseinheit dazu eingerichtet und dafür vorgesehen ist diese Änderung zu messen und/oder zu speichern, sodass ein kapazitiver Feuchtesensor entsteht.

Ein kapazitiver Feuchtesensor ist im Prinzip ein Kondensator, dessen Dielektrikum vorzugsweise aus einem hygroskopischen Polymerschicht besteht, die entsprechend der Feuchtigkeit der Umgebungsluft Feuchtigkeit aufnimmt (absorbiert) oder abgibt (desorbiert) bis ein Gleichgewichtszustand (Diffusionsgefälle ist = 0) erreicht ist. Dabei verändert sich die Dielektrizitätskonstante des Polymermaterials als Funktion eines Feuchtegehalts.

Die Aufgabe der Verarbeitungseinheit besteht unter anderem darin, vorzugsweise auch aus einer gemessenen Umgebungstemperatur und dem feuchtigkeitsabhängigen Kapazitätswert des Sensors die relative Feuchte möglichst genau zu ermitteln.

Gemäß zumindest einer Ausführungsform umfasst die Vorrichtung zur Messung von Druck und/oder Feuchtigkeit zumindest einen Sensor zur Messung von Druck und/oder Feuchtigkeit, wobei der Sensor zumindest einen Kondensator mit zumindest zwei Elektroden umfasst, welche insbesondere in einer horizontalen Richtung entlang eines und auf einem insbesondere flexiblen Trägermaterial zueinander angeordnet sind, wobei zwischen den Elektroden zumindest eine dielektrische Schicht angeordnet ist.

Erfindungsgemäß ist auf eine dem Trägermaterial abgewandten Seite zumindest eine Elektrode und/oder dielektrische Schicht zumindest stellenweise, zumindest eine, zumindest teilweise flüssigkeitsdurchlässige und/oder flüssigkeitsabsorbierende Schicht (= Feuchteschicht) angeordnet, wobei somit die zumindest eine Elektrode und/oder dielektrische Schicht in Querrichtung zwischen dem Trägermaterial und der Feuchteschicht angeordnet sind, sodass eine Kapazität durch die auf die dielektrische Schicht zumindest teilweise treffende Flüssigkeit, zumindest teilweise verändert wird, wobei eine Verarbeitungseinheit dazu eingerichtet und dafür vorgesehen ist diese Änderung zu messen und/oder zu speichern, sodass ein kapazitiver Feuchtesensor entsteht.

Die Feuchteschicht kann mit einem dielektrischen Material gebildet sein. Das Material der Feuchteschicht kann verschieden von dem Material der wasserundurchlässigen Schicht sein.

Der Sensor und/oder die Verarbeitungseinheit können mittels einer Batterie oder einer Festnetzstromversorgung mit elektrischer Energie versorgt werden.

Alternativ oder zusätzlich ist die Erzeugung von elektrischer Energie zur Versorgung des Sensors und/oder Verarbeitungseinheit mittels sogenannten "Energy Harvesting" möglich.

Als Energy Harvesting (wörtlich übersetzt *Energie-Ernten*) bezeichnet man die Gewinnung kleiner Mengen von elektrischer Energie aus Quellen wie Umgebungstemperatur, Vibrationen oder Luftströmungen für mobile Geräte mit geringer Leistung. Die dafür eingesetzten Strukturen werden auch als Nanogenerator bezeichnet. Energy Harvesting vermeidet bei Drahtlostechnologien Einschränkungen durch kabelgebundene Stromversorgung oder Batterien.

Möglichkeiten des Energy Harvesting:
- Piezoelektrische Kristalle erzeugen bei Krafteinwirkung, beispielsweise durch Druck oder Vibration, elektrische Spannungen. Diese Kristalle können an oder auf dem Trägermaterial angeordnet sein.
- Thermoelektrische Generatoren und pyroelektrische Kristalle gewinnen aus Temperaturunterschieden elektrische Energie. Diese Generatoren können an oder auf dem Trägermaterial angeordnet sein.
- Über Antennen kann die Energie von Radiowellen, eine Form von elektromagnetischer Strahlung, aufgefangen und energetisch verwendet werden. Ein Beispiel dafür sind die passiven RFIDs. Diese Antennen können an oder auf dem Trägermaterial angeordnet sein.
- Photovoltaik, elektrische Energie aus der Umgebungsbeleuchtung.
- Osmose.

Gemäß zumindest einer Ausführungsform ist der Sensor zusätzlich ein kapazitiver Drucksensor, wobei die Verarbeitungseinheit zusätzlich dazu eingerichtet und dafür vorgesehen ist, eine durch äußeren Druck verursachte Kapazitätsänderung des Kondensators zu messen und/oder zu speichern.

Grundsätzlich handelt es sich bei einem kapazitiven Sensor also um einen Sensor, welcher auf Basis der Veränderung der elektrischen Kapazität eines einzelnen Kondensators oder eines Kondensatorsystems arbeitet. Die Beeinflussung der Kapazität durch die zu erfassende Größe kann dabei auf verschiedene Arten erfolgen, die primär durch den Verwendungszweck bestimmt ist.

Ein kapazitiver Sensor basiert unter anderem darauf, dass zwei Elektroden, einer davon kann die zumessende Oberfläche sein, die "Platten" eines elektrischen Kondensators bilden, dessen Kapazität oder Kapazitätsänderung gemessen wird, die folgendermaßen beeinflusst werden kann:
- Eine Platte wird durch den zumessenden Effekt verschoben und/oder verformt, wodurch sich der Plattenabstand und damit die elektrische messbare Kapazität ändern.
- Die Platten sind starr und die Kapazität an Sich ändert sich dadurch, dass ein elektrisch leitendes Material oder ein Dielektrikum in unmittelbare Nähe gebracht wird.
- Die wirksame Plattenfläche ändert sich, indem die Platten wie bei einem Drehkondensator gegeneinander verschoben werden.

Um auch kleine Veränderungen besser detektieren zu können kann die eigentliche Messelektrode häufig mit einer Schirmelektrode umgeben sein, die den inhomogenen Randbereich des elektrischen Feldes von der Messelektrode abschirmt, dadurch ergibt sich zwischen Messelektroden üblicherweise geerdeter Gegenelektrode eine annähernd paralleles elektrisches Feld mit der bekannten Charakteristik eines idealen Plattenkondensators.

Ein kapazitiver Drucksensor ist insbesondere ein solcher bei dem die Kapazitätsänderung infolge des Durchbiegens einer Membran und der resultierenden Änderung des Plattenabstands als Sensoreffekt ausgewertet wird. Zum Beispiel handelt es sich bei der Membran um das oben genannte Dielektrikum oder aber um die einzelnen Kondensatorelektroden, welche insbesondere in Form einer Platte ausgeführt sein können. Mit anderen Worten ist in einer derartigen Ausführungsform in neuartiger Art und Weise ein kapazitiver Feuchtesensor mit einem kapazitiven Drucksensor kombiniert, jedoch ohne dass diese Bauteile voneinander getrennte Elemente oder zwei separate Sensoren bildeten, sondern es handelt sich bei vorliegender Ausführungsform um ein "Two in One"-Konzept, in welchem der gleiche Sensor sowohl als Feuchtesensor als auch als Drucksensor fungiert.

Gemäß zumindest einer Ausführungsform handelt es sich bei dem Trägermaterial um einen Webstoff, insbesondere in welchem elektrische Leiterbahnen zur elektrischen Kontaktierung des Sensors und der Verarbeitungseinheit eingewoben sind.

Bei einem Webstoff handelt es sich im Sinne der Erfindung daher um ein Gewebe, welches manuell oder maschinell auf Basis von einzelnen Fäden gewebt wurde.

Die elektrischen Leiterbahnen können in einem Gewebe daher zusätzlich neben den üblichen Fasern und Gewebesträngen integriert sein oder aber einzelne Gewebestränge, welche das Gewebenetz ausbilden ersetzen.

Je nach Abstand und Eigenschaften der einzelnen Fäden (hochgedreht, bauschig, usw.) können ganz lockere Gewebe, wie Verbandgewebe oder Dichtegewebe wie Brokatstoff entstehen. Längselastisch werden Gewebe durch, als Kettenfäden eingesetzte Gummifäden (mehr Bändern verwendet) oder Kräusel- und Bauschgarne verwendet. Sie werden gespannt, verarbeitet und ziehen sich im Ruhezustand zusammen. Bauschgarne bestehen aus texturierten, also gekräuselten, synthetischen Fasern. Die Kräuselung verändert die Eigenschaften der synthetischen Fasern. Die darauf gesponnenen Garne sind sehr elastisch und voluminös und haben eine gute Wärmedämmung.

Zum Beispiel kann das Trägermaterial Teil eines Bezugstoffes eines Sitzes, insbesondere eines Fahrzeugsitzes oder eines Bürostuhls, sein. Insofern kann der Sensor, vorzugsweise jedoch die gesamte Vorrichtung, auf dem Bezugsstoff eines solchen Sitzes aufgebracht oder in einen solchen integriert sein.

Zum Beispiel ist die Verarbeitungseinheit dazu eingerichtet und dafür vorgesehen, die einzelnen Feuchte- sowie Druckwerte zu erfassen und aus einer Kombination der einzelnen Feuchte- und Druckwerte zumindest einen jeweiligen Kennwert zu ermitteln, aus welchem ableitbar ist, welches Individuum (mit Gewicht und/oder Größe) gerade den Fahrzeugsitz besetzt.

Zum Beispiel kann aus der Druckmessung durch die Verarbeitungseinheit ein Gewicht der jeweiligen Person abgeleitet und festgestellt werden. Auch kann die jeweilige Feuchtigkeit, welche die jeweilige Person an den Sensor abgibt, gemessen werden, wobei der jeweilige Kennwert zum Beispiel ein Produkt aus dem relativen Feuchtigkeitswert mal der von der Verarbeitungseinheit ermittelten Belastungsgewicht ist.

Überschreitet ein derartiger Kennwert einen entsprechenden Grenzwert kann die Verarbeitungseinheit insbesondere mittels einer Anbindung an die Elektronik des Fahrzeugs, eine Warnung aussprechen. Diese Warnung kann dahingehend lauten, dass der Sitz überbelegt ist oder der Fahrer zu stark schwitzt. Diese Warnung kann jedoch auch ersetzt werden durch eine entsprechende Anzeige dahingehend welcher Belegungstyp den Sitz nutzt. Bei einem Belegungstyp kann es sich um eine Gewichtsklassifikation eines jeweiligen Benutzers handeln, oder aber auch darum Handeln ob es sich bei dem Benutzer um ein Tier, einen Menschen oder auch um eine Sache handelt. Vorzugsweise ist daher die Verarbeitungseinheit in eine Anzeigenelektronik des Fahrzeugs integrierbar, zumindest jedoch mit einer solchen verbindbar.

Hierzu ist denkbar, dass die Verarbeitungseinheit sich zum Beispiel mittels Bluetooth oder einer sonstigen Wireless Verbindung mit einer Empfangseinheit des Fahrzeugs verbindet und der jeweilige Kenn- oder Grenzwert und/oder die jeweilige Warnung und/oder die jeweilige Identifikation des Benutzers auf einem Display des Fahrzeugs wiedergegeben werden.

Alternativ oder zusätzlich ist vorstellbar, dass diese einzelnen Werte und/oder Identifikationen auch extern abrufbar und/oder extern darstellbar sind. Zum Beispiel kann das Auto auf eine Überbelegung hin von einem externen Controller überwacht werden.

Zum Beispiel kann mittels einer Datenverbindung die Verarbeitungseinheit mit einer Auslöseinheit eines Airbags in Verbindung stehen, sodass die Verarbeitungseinheit auch die Auslöseinheit steuern und/oder regeln kann, insbesondere in Bezug auf einen Auslösezeitpunkt des Airbags. Zusätzlich und/oder alternativ ist es möglich, dass die Verarbeitungseinheit eine Controllereinheit des Airbags mit Daten zum Beispiel im Hinblick auf einen Belegungstyp, Position und/oder Gewicht eines Benutzers des Fahrzeugsitzes versorgt.

Diese Daten können dazu führen, dass der Auslösezeitpunkt und die Auslösereihenfolge des Airbags auf den Benutzer angepasst sind, sodass ein Personenschaden an dem Benutzer vermieden wird.

Gemäß zumindest einer Ausführungsform ist zumindest eine Elektrode und/oder dielektrische Schicht auf dem Trägermaterial oder auf einer auf dem Trägermaterial angeordneten, insbesondere wasserundurchlässigen Schicht aufgedruckt oder mittels eines Dünnschichtverfahrens aufgebracht.

Dies heißt, dass zumindest ein Element, vorzugsweise sowohl die Elektrode als auch die dielektrische Schicht, auf dem Trägermaterial oder einer zwischen dem Sensor und dem Trägermaterial aufgebrachten vorzugsweise elektrisch nicht leitfähigen, weiter vorzugsweise wasserundurchlässigen Schicht mittels eines Druckverfahrens aufgedruckt.

Bei dem Druckverfahren kann es sich zum Beispiel um ein Inkjetverfahren handeln.

Zum Beispiel ist die Verarbeitungseinheit in der gleichen Weise wie der Sensor auf das Trägermaterial aufgebracht. Hierzu ist vorstellbar, dass auch die Verarbeitungseinheit, zumindest jedoch eine, insbesondere leitende, Schicht der Verarbeitungseinheit auf das Trägermaterial zum Beispiel aufgedruckt ist. Die Datenkommunikation zwischen der Verarbeitungseinheit und dem Sensor kann dann über die oben genannten Leiterbahnen entstehen. Diese Leiterbahnen können zumindest teilweise, vorzugsweise jedoch vollständig, in den Webstoff eingewoben sein oder sogar einzelne Fasern des Webstoffs selbst ausbilden.

Zum Beispiel ist zumindest eine Elektrode flächig ausgeführt. Das heißt, dass eine Dicke der Elektrode im Vergleich zu deren Flächenausdehnung vernachlässigbar ist. Eine solche Elektrode kann daher insbesondre mittels eines Druckverfahrens hergestellt werden.

Alternativ hierzu kann eine Dicke zumindest einer Elektrode höchstens 5 mm betragen. Hierzu kann das Druckverfahren mehrmals angewandt werden, sodass zumindest zwei, vorzugsweise jedoch dann mehr, Einzeldruckschichten übereinandergestapelt werden.

Des Weiteren kann die Elektrode auch mittels eines 3D-Druckverfahrens auf dem Trägermaterial angeordnet sein.

### 1. Das FDM-Verfahren (Fused Deposition Modeling)

### Alternativbezeichnungen: Fused Filament Fabrication (FFF), Fused Layer Modeling (FLM)

Das Verfahren bezeichnet schichtweises Auftragen (Extrusion) eines Materials durch eine heiße Düse. Das Verbrauchsmaterial befindet sich in Form eines langen Drahts (sog. Filament) auf einer Rolle und wird durch die Fördereinheit in einen Druckkopf geschoben, dort eingeschmolzen und auf einem Druckbett ausgebracht. Druckkopf und/oder Druckbett sind dabei in drei Richtungen beweglich. So können Kunststoffschichten schrittweise aufeinander aufgebracht werden.

### 2. Das SLS Verfahren (Selektives Lasersintern)

Im Unterschied zum Sinterverfahren, bei dem Stoffe in Pulverform unter Hitzeeinwirkung miteinander verbunden werden, geschieht dies beim SLS-Verfahren selektiv durch einen Laser (alternativ auch Elektronenstrahl oder Infrarotstrahl). Es wird also nur ein bestimmter Teil des Pulvers miteinander verschmolzen.

Dazu wird stets eine dünne Pulverschicht von der Beschichtungseinheit auf dem Druckbett ausgebracht. Der Laser (oder andere Energiequelle) wird nun punktgenau auf einzelne Stellen der Pulverschicht ausgerichtet, um die erste Schicht der Druckdaten auszubilden. Hierbei wird das Pulver an- oder aufgeschmolzen und verfestigt sich anschließend wieder durch geringfügiges Abkühlen. Das nicht aufgeschmolzene Pulver bleibt um die gesinterten Bereiche herum liegen und dient als Stützmaterial. Nachdem eine Schicht verfestigt ist, senkt sich das Druckbett um den Bruchteil eines Millimeters ab. Die Beschichtungseinheit fährt nun über das Druckbett und bringt die nächste Pulverschicht aus. Anschließend wird die zweite

Schicht der Druckdaten durch den Laser (oder eine andere Energiequelle) gesintert. So entsteht schichtweise ein dreidimensionales Objekt.

### 3. Three-Dimensional Printing (3DP)

Das 3DP-Verfahren funktioniert sehr ähnlich wie das selektive Lasersintern, doch anstelle einer gerichteten Energiequelle verfährt ein Druckkopf über das Pulver. Dieser gibt winzige Tröpfchen von Bindemittel auf die zugrunde liegenden Pulverschichten ab, die so miteinander verbunden werden. Ansonsten ist dieses Verfahren dem SLS-Verfahren gleich.

### 4. Stereolithographie (SLA)

Anstelle eines Kunststoffdrahts oder Druckmaterials in Pulverform kommen beim Stereolithographie-Verfahren flüssige Harze, sog. Photopolymere, zum Einsatz. Sie werden schichtweise durch UV-Strahlung verhärtet und erzeugen so dreidimensionale Objekte. Dafür wird die Bauplattform im Harzbecken schrittweise abgesenkt. Es gibt auch Varianten (sog. Polyjet-Verfahren) ohne ein ganzes Becken mit flüssigem Harz. Dafür wird ein Epoxidharz tröpfchenweise aus einer Düse aufgebracht und durch einen UV-Laser sofort ausgehärtet.

### 5. Laminated Object Manufacturing (LOM)

### Alternativbezeichnung: Layer Laminated Manufacturing (LLM)

Das Verfahren basiert weder auf chemischen Reaktionen, noch auf einem thermischen Prozess. Es wird dabei mit einem trennenden Werkzeug (z.B. einem Messer oder Kohlendioxidlaser), einer Folie oder einer Platte (z.B. Papier) an der Kontur geschnitten und schichtweise aufeinander geklebt. So entsteht durch Absenken der Bauplattform ein Schichtobjekt aus geklebten, übereinanderliegenden Folien.

Eine oder mehrere wasserundurchlässige Schichten und/oder auch die Feuchteschicht können in derselben Art und/oder Dicke wie die Elektrode aufgebracht werden.

Gemäß zumindest einer Ausführungsform bedeckt die Feuchteschicht den Kondensator vollständig.

Dies kann heißen, dass die Feuchteschicht, nach außen, das heißt in der Querrichtung den Sensor nach außen abgrenzt und abschließt, sodass der Sensor zwischen der Feuchteschicht und dem Trägermaterial angeordnet ist.

Gemäß zumindest einer Ausführungsform weist der Sensor zumindest einen weiteren Kondensator auf, welcher in der Querrichtung unter oder über dem Kondensator angeordnet und durch eine weitere wasserundurchlässige Schicht beabstandet von dem Kondensator auf oder unter dieser weiteren wasserundurchlässigen Schicht angeordnet ist, sodass ein Kondensatorenstack entsteht.

Der weitere Kondensator kann in der gleichen Weise wie der Kondensator aufgebaut sein und ebenso in einer gleichen Weise wie der Kondensator auf die weitere wasserundurchlässige Schicht angeordnet sein.

Mittels eines derartigen Kondensatorenstacks kann die Sensorik ganz besonders einfach verfeinert werden nämlich insofern, als dass denkbar ist das bei zwei den Kondensatorstack ausbildenden Sensoren beide Sensoren die gleichen Aufgaben verrichten, jedoch durch die einzelnen Sensoren jeweilige Messwerte ermittelt werden, die zusammen genommen auf einen Mittelwert schließen lassen. Zum Beispiel wird von jedem der beiden Sensoren jeweils die (relative) Feuchtigkeit der Umgebung gemessen wobei aus diesen beiden Messwerten dann der Feuchtigkeitsmittelwert ermittelt wird. Gleiches kann entsprechend mit der Druckmessung geschehen, sodass die Genauigkeit der gesamten Messung insbesondere einer Kombination der Messungen von (relativer) Feuchtigkeit und dem jeweiligen Druck besonders genau ausgestaltet werden kann.

Gemäß zumindest einer Ausführungsform bildet die wasserundurchlässige Schicht und/oder die weitere wasserundurchlässige Schicht die dielektrische Sicht zumindest teilweise selbst aus.

Dies kann heißen, dass ein anstatt der separaten Positionierung einer dielektrischen Schicht neben der wasserundurchlässigen Schicht und/oder neben der weiteren wasserundurchlässigen Schicht, diese dielektrische Schicht selbst durch die wasserundurchlässige Schicht und/oder die weitere wasserundurchlässige Schicht gebildet ist.

Eine derartige Erzeugung der dielektrischen Schicht durch die wasserundurchlässigen Schicht(en) bildet daher ein besonders einfaches und kostengünstiges Herstellungsverfahren zu einer kostengünstigen Vorrichtung.

Davon abgesehen kann grundsätzlich vorgesehen sein die Elektroden, die dielektrische Schicht und die wasserundurchlässige Schicht(en) derart zueinander anzuordnen, dass ein elektrischer Kurzschluss in jedem Fall verhindert ist.

Gemäß zumindest einer Ausführungsform beträgt eine maximale Dicke der Feuchteschicht wenigstens 30 % und höchstens 80 % der maximalen Dicke der wasserundurchlässigen Schicht und/oder der maximalen Dicke der weiteren wasserundurchlässigen Schicht.

Dies stellt nicht nur einen besonders flach gebauten Sensor sicher, sondern gewährleistet auch eine besonders schnelle Reaktionszeit auf Feuchtigkeitsveränderungen. Die von außen auf die Feuchteschicht einwirkende Feuchtigkeit muss daher keine großen Strecken zu dem Dielektrikum durchwandern.

Des Weiteren betrifft die vorliegende Erfindung ein Verfahren zur Messung von Druck und/oder Feuchtigkeit wobei insbesondere angemerkt sei, dass alle für die obig beschriebene Vorrichtung offenbarten Merkmale auch für das hier beschriebene Verfahren offenbart sind und umgekehrt.

Gemäß zumindest einer Ausführungsform umfasst das Verfahren zu Messung von Druck und/oder Feuchtigkeit zunächst einen ersten Schritt mittels welchem zumindest ein Sensor zu Messung von Druck und/oder Feuchtigkeit bereitgestellt wird, wobei der Sensor zumindest einen Kondensator mit zumindest zwei Elektroden, welche, insbesondere in einer horizontalen Richtung entlang eines und auf einem, insbesondere flexiblem, Trägermaterial zueinander angeordnet sind aufweist, wobei zwischen den Elektroden zumindest eine dielektrische Schicht angeordnet ist.

Erfindungsgemäß ist auf einer dem Trägermaterialabgewandten Seite zumindest einer Elektrode und/oder der dielektrischen Schicht zumindest stellenweise, zumindest eine, zumindest teilweise flüssigkeitsdurchlässige und/oder flüssigkeitsabsorbierende Feuchteschicht angeordnet, wobei somit die zumindest eine Elektrode und/oder die dielektrische Schicht in einer Querrichtung zwischen dem Trägermaterial und der Feuchteschicht angeordnet sind, sodass sich eine Kapazität durch die auf die dielektrische Schicht zumindest teilweise treffende Flüssigkeit zumindest teilweise verändert, wobei eine Verarbeitungseinheit diese Änderung misst und/oder speichert, sodass ein kapazitiver Feuchtesensor entsteht.

Dabei weist das oben beschrieben Verfahren die gleichen Vorteile und vorteilhaften Ausgestaltungen wie die obig beschriebene Vorrichtung auf.

Im Folgenden wird die hier beschriebene Erfindung anhand zweier Ausführungsbeispiele und den dazugehörigen Figuren näher beschrieben.

Gleiche oder gleichwirkende Bestandteile sind mit den gleichen Bezugszeichen versehen.

In der Figur 1 ist in einem ersten Ausführungsbeispiel eine erfindungsgemäße Vorrichtung zur Messung von Druck und/oder Feuchtigkeit gezeigt.

In der Figur 2 ist einer schematisch perspektivischen Ansicht eine in Bezug auf die Schichtenordnung dargestellte Explosionszeichnung dargestellt.

In der Figur 3 ist ein weiteres Ausführungsbeispiel einer hier beschriebenen Vorrichtung gezeigt.

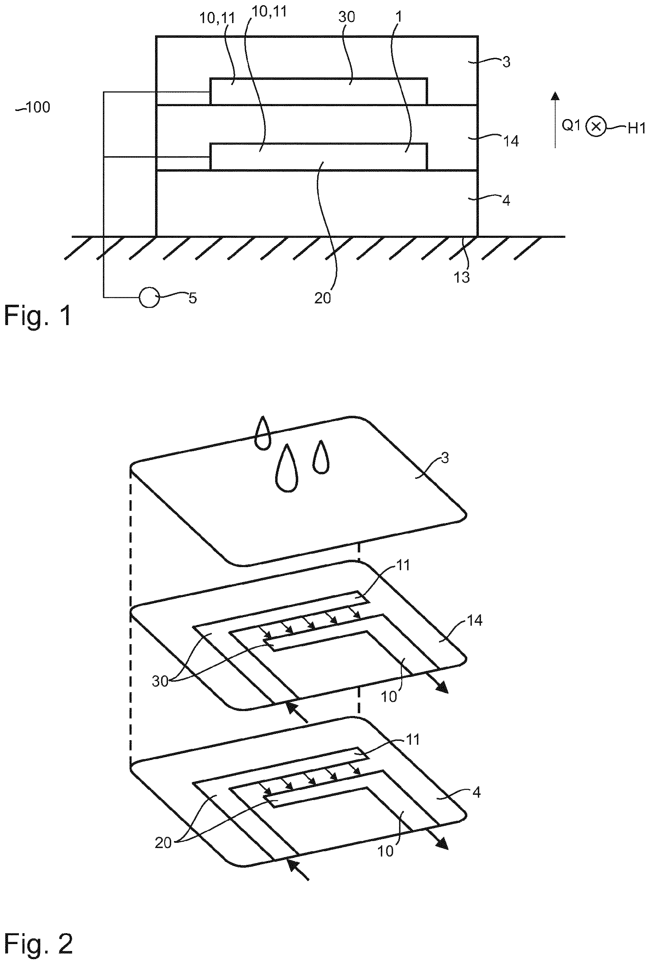

Wie nun der Figur 1 entnommen werden kann, ist dort eine Vorrichtung 100 zur Messung von Druck und/oder Feuchtigkeit gezeigt.

Beispielhaft ist dort ein Sensor 1 dargestellt, wobei der Sensor 1 einen Kondensatorstack zeigt mit einem Kondensator 20, sowie einem Kondensator 30, wobei die einzelnen Elektroden 10, 11 der Kondensatoren 20, 30 in der horizontalen Richtung H1 übereinander angeordnet sind, wobei alternativ hierzu jedoch selbstverständlich eine Anordnung der einzelnen Elektroden 10, 11 eines einzelnen Kondensators 20, 30 in der Querrichtung Q1 welche senkrecht zur horizontalen Richtung H1 verläuft und damit auch senkrecht zur Haupterstreckungsrichtung des dort gezeigten Sensors 1 verlaufen oder angeordnet sein können.

Die einzelnen Elektroden 10, 11 sind auf einem Trägermaterial 13 angeordnet. Bei dem Trägermaterial 13 kann es sich insbesondere um einen Webstoff, insbesondere um einen flexiblen Webstoff handeln.

Auf dem Trägermaterial 13 ist eine wasserundurchlässige Schicht 4 angeordnet, wobei auf dieser wasserundurchlässigen Schicht 4 die beiden Elektroden 10, 11 des Kondensators 20 in der horizontalen Richtung H1 aufgedruckt sind.

Die Elektroden 10, 11 des Kondensators 20 sind vollständig von einer weiteren wasserundurchlässigen Schicht 14 umgeben. Auf dieser wasserundurchlässigen Schicht 14 ist in der gleichen Art und Weise der weitere Kondensator 30 mit entsprechenden Elektroden 10, 11 aufgedruckt. Zudem sind in dem vorliegenden Ausführungsbeispiel freiliegende Außenflächen der einzelnen Elektroden 10, 11 des weiteren Kondensators 30 vorzugsweise vollständig von einer wasserdurchlässigen und/oder wasserabsorbierenden Feuchteschicht 3 umgeben.

Über diese Feuchteschicht 3 kann Wasser auf eine dielektrische Schicht 4 treffen, welche vorliegend in der horizontalen Richtung H1 zwischen den jeweiligen Elektroden 10, 11 eines Kondensators 20, 30 angeordnet ist.

Im vorliegenden Ausführungsbeispiel der Figuren 1 und 2 bildet die wasserundurchlässige Schicht 4 selbst eine dielektrische Schicht 4 des Kondensators 20 auf. Selbiges gilt für die weitere wasserundurchlässige Schicht 14 in Bezug auf den weiteren Kondensator 30.

Durch Auftreffen und Durchdringen der Feuchtigkeit über die Feuchteschicht 3 werden die dielektrischen Eigenschaften insbesondere der dielektrischen Schicht 2 des weiteren Kondensators 30 verändert.

Darüber hinaus ist eine Verarbeitungseinheit 5 erkennbar, welche in datentechnischer Verdingung mit den beiden Kondensatoren 20, 30 steht, wobei diese Verarbeitungseinheit 5 dazu eingerichtet und dafür vorgesehen ist, eine Änderung der relativen Feuchtigkeit der Umgebung und/oder der Feuchteschicht 3 zu messen.

Durch die in der Figur 1 dargestellte "stackwise"-Anordnung und dadurch, dass die weitere wasserundurchlässige Schicht 14 verhindert, dass der Kondensator 20 mit Feuchtigkeit in Kontakt kommt, kann daher vorgesehen sein, dass lediglich der weitere Kondensator 30 und dessen dielektrische Schicht 4 der Feuchtigkeit ausgesetzt ist. Hierzu kann die Verarbeitungseinheit 5 dann eine Veränderung der Kapazität des weiteren Kondensators 30 vergleichen mit der stabilen Kondensatorkapazität des Kondensators 10, sodass hierzu ein besonders einfacher Vergleich in der Veränderung der relativen Feuchtigkeit und/auch des jeweiligen Belastungsdruckes hergestellt sein kann.

Durch den in der Figur 1 dargestellten Pfeil ist auch eine Druckrichtung, unter welcher der Sensor 1 mit Druck beaufschlagt wird, gezeigt. Beides kann vorzugsweise durch den Sensor 1 und insbesondere durch die Vorrichtung 100 gemessen, ausgewertet und gespeichert werden. Hierzu dient insbesondere die in der Erfindung als wesentlich dargestellte Verarbeitungseinheit 5, welche zusätzlich auch entsprechende Druckwerte und insofern damit verbundene Änderungen in der Kapazität der einzelnen Sensoren 1 messen und auswerten kann, sodass die Verarbeitungseinheit 5 zusätzlich dazu eingerichtet und dafür vorgesehen ist eine durch äußeren Druck verursachte Kapazitätsänderung des Kondensators 20 und insbesondere auch des weiteren Kondensators 30 zu messen und/oder zu speichern.

Die Feuchteschicht 3 kann flexibel oder nicht flexibel ausgebildet sein. Zudem ist es möglich, dass die Feuchteschicht 3 als Webstoff ausgebildet ist. Insbesondere kann es sich um einen Webstoff handeln, welcher im einleitenden Teil der vorliegenden Anmeldung beispielhaft genannt wurde. Zudem ist es jedoch auch möglich, dass es sich bei der Feuchteschicht 3 um ein Substrat handelt welches, zum Beispiel in Form eines Epitaxie- oder eines Klebeprozesses auf den weiteren Kondensator 30 aufgebracht, zum Beispiel aufgeklebt wurde.

Die wasserundurchlässige Schicht 14 und/oder die wasserundurchlässige Schicht 15 können ebenso flexibel und nicht flexibel, insbesondere auch ebenso in Form eines Webstoffes oder eines Substrats in der gleichen Weise wie die Feuchteschicht 3 ausgebildet sein.

Zudem ist vorteilhaft denkbar, dass die Elektroden 10, 11 der beiden Kondensatoren 20, 30 auf die wasserundurchlässige Schicht 14 und die weitere wasserundurchlässige Schicht 15 in Form eines Druckprozesses zum Beispiel eines Tintenstrahldruckprozesses aufgedruckt wurden.

In der Figur 2 ist eine Explosionszeichnung gezeigt, wobei insbesondere aus der Figur 2 die jeweilige Anordnung der Elektroden 10, 11 der Kondensatoren 20, 30 hervorgeht. Erkennbar ist wiederum die durch die Pfeilrichtung dargestellte Krafteinwirkung auf den Sensor 1, sowie durch die einzelnen schematisch dargestellten Tropfen einwirkende Feuchtigkeit. Insbesondere ist wiederum erkennbar, dass die Feuchtigkeit insbesondere zwischen den Elektroden 10, 11 eindringt und auf die jeweilige wasserdurchlässige Schicht 14 einen zum Beispiel erheblichen Effekt auf die elektrische Eigenschaft hat, sodass sich die Kapazität zumindest des weiteren Kondensators 30 wie in der Figur 1 erläutert jeweils ändert.

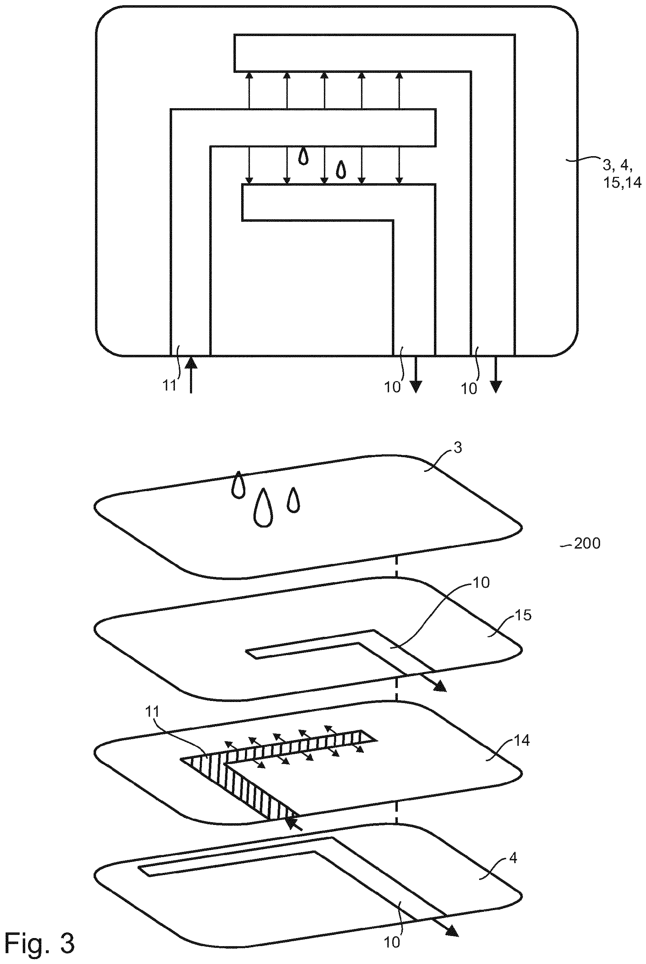

In der Figur 3 ist in einer weiteren Ausführungsform der hier beschriebenen Erfindung gezeigt, dass der Sensor 1 aus zwei Elektroden 10, sowie einer Elektrode 11 bestehen kann. Die Elektroden 10 haben eine Polarität (vorzugsweise die gleiche Polarität), während die Elektrode 11 eine davon unterschiedliche Polarität aufweist, wobei jedoch im rechten Teilbild der Figur 3 die Explosionszeichnung des linken Teils der Figur 3 gezeigt ist und erkennbar ist, dass drei wasserundurchlässige Schichten 4, 14, 15 verwendet werden. Die Elektroden 10 können auch unterschiedliche Polaritäten und/oder elektrische Potentiale aufweisen. Auch können die Elektroden 10 miteinander elektrisch verbunden sein.

Zum Beispiel können die Elektroden 10, 11 auch jeweils eine separate Polarität und/oder ein separates elektrisches Potential aufweisen und/oder generieren. Entsprechendes kann auch für die in den hier folgenden Figuren in Bezug auf die Elektroden gelten.

Zum Beispiel ist die unterste wasserundurchlässige Schicht wiederum die wasserundurchlässige Schicht 14, die darauffolgende wasserundurchlässige Schicht 15 und die in der Querrichtung Q1 darauf angeordnete wasserundurchlässige Schicht 16 eine weitere wasserundurchlässige Schicht, wobei jeweils eine Elektrode auf einer separaten wasserundurchlässigen Schicht jeweils aufgebracht insbesondere aufgedruckt ist.

In dieser Stackung der einzelnen wasserundurchlässigen Schichten 14, 15 und 16 wird daher durch Zusammenführen dieser Schichten der im linken Teil der Figur 3 gezeigte Kondensator 20 erzeugt, wobei hierbei in der Querrichtung Q1, die Elektroden 10 jeweils, wie im dementsprechenden Teilbild entnommen werden kann auf unterschiedlichen Ebenen angeordnet sin.

Alternativ hierzu kann auch die Elektrode 11 zusammen mit zumindest einer der Elektroden 10 in einer gemeinsamen Ebene, das heißt auf oder in einer gemeinsamen wasserundurchlässigen Schicht 4, 14, 15 aufgebracht werden, sodass zum Beispiel nur noch die zweite der Elektroden 10 auf eine separaten wasserundurchlässigen Schicht 4, 14, 15 aufgestackt werden muss.

Grundsätzlich können daher die einzelnen Elektroden 10,11 in unterschiedlichen Ebenen in der Q1-Richtung zueinander angeordnet sein. Zum Beispiel gilt eine paarweise Zuordnung zwischen genau einer wasserundurchlässigen Schicht 4, 14, 15 mit genau einer Elektrode 10, 11.

Die Erfindung ist nicht durch die Beschreibung anhand des Ausführungsbeispiels beschränkt. Vielmehr umfasst die Erfindung jedes neue Merkmal, sowie jede Kombination von Merkmalen was insbesondere jede Kombination von Merkmalen in den Patentansprüchen beinhaltet, auch wenn dieses Merkmal oder diese Kombination selbst nicht explizit in den Patentansprüchen oder in den Ausführungsbeispielen angegeben ist.

### Bezugszeichenliste

- 1: Sensor
- 3: Feuchteschicht
- 4: dielektrische Schicht/ wasserundurchlässige Schicht
- 5: Verarbeitungseinheit
- 10: Elektrode
- 11: Elektrode
- 12: Elektrode
- 13: Trägermaterial
- 14: wasserundurchlässige Schicht
- 15: wasserundurchlässige Schicht
- 20: Kondensator
- 30: Kondensator
- 100: Vorrichtung
- 200: Verfahren

- H1: horizontalen Richtung
- Q1: Querrichtung

## Patentansprüche

1. Vorrichtung (100) zur Messung von Druck und/oder Feuchtigkeit umfassend zumindest einen Sensor (1) zur Messung von Druck und/oder Feuchtigkeit, wobei der Sensor (1)
- zumindest einen Kondensator (20) mit zumindest zwei Elektroden (10, 11), welche, insbesondere in einer horizontalen Richtung (H1) entlang eines und auf einem, insbesondere flexiblem, Trägermaterial (13) zueinander angeordnet sind, wobei zwischen den Elektroden (10, 11) zumindest eine dielektrische Schicht (4) angeordnet ist,
**dadurch gekennzeichnet, dass**
auf einer dem Trägermaterial (13) abgewandten Seite zumindest einer Elektrode (10, 11) und/oder der dielektrischen Schicht (4) zumindest stellenweise zumindest eine zumindest teilweise flüssigkeitsdurchlässige und/oder flüssigkeitsabsorbierende Feuchteschicht (3) angeordnet ist, wobei somit die zumindest eine Elektrode (10, 11) und/oder die dielektrische Schicht (4) in einer Querrichtung (Q1) zwischen dem Trägermaterial (13) und der Feuchteschicht (3) angeordnet sind, sodass sich eine Kapazität durch die auf die dielektrische Schicht (4) zumindest teilweise treffende Flüssigkeit zumindest teilweise verändert, wobei eine Verarbeitungseinheit (5) dazu eingerichtet und dafür vorgesehen ist diese Änderung zu messen und/oder zu speichern, sodass ein kapazitiver Feuchtesensor entsteht.

2. Vorrichtung (100) nach Anspruch 1,
**dadurch gekennzeichnet, dass**
der Sensor (1) zusätzlich ein kapazitiver Drucksensor ist, wobei die Verarbeitungseinheit (5) zusätzlich dazu eingerichtet und dafür vorgesehen ist eine durch äußeren Druck verursachte Kapazitätsänderung des Kondensators (20) zu messen und/oder zu speichern.

3. Vorrichtung (100) nach Anspruch 1 oder 2,
**dadurch gekennzeichnet, dass**
es sich bei dem Trägermaterial (13) um einen Webstoff handelt, insbesondere in welchen elektrische Leiterbahnen zur elektrischen Kontaktierung des Sensors (1) und der Verarbeitungseinheit (5) eingewoben sind.

4. Vorrichtung (100) nach zumindest einem der vorhergehenden Ansprüche,
**dadurch gekennzeichnet, dass**
zumindest eine Elektrode (10, 11) und/oder die dielektrische Schicht (4) auf das Trägermaterial (13) oder eine auf dem Trägermaterial (13) angeordnete, insbesondere wasserundurchlässige Schicht (14), aufgedruckt oder mittels eine Dünnschichtverfahrens aufgebracht ist.

5. Vorrichtung (100) nach Anspruch 1,
**dadurch gekennzeichnet, dass**
die Feuchteschicht (3) den Kondensator (20) vollständig bedeckt.

6. Vorrichtung (100) nach Anspruch 1,
**dadurch gekennzeichnet, dass**
der Sensor (1) zumindest einen weiteren Kondensator (30) aufweist, welcher in der Querrichtung (Q1) über oder unter dem Kondensator (20) angeordnet und durch eine weitere wasserundurchlässige Schicht (15) beabstandet von dem Kondensator (20) auf oder unter dieser weiteren wasserundurchlässigen Schicht (15) angeordnet ist, sodass ein Kondensatorstack entsteht.

7. Vorrichtung (100) nach dem vorhergehenden Anspruch,
**dadurch gekennzeichnet, dass**
die wasserundurchlässigen Schicht (14) und/oder die weitere wasserundurchlässige Schicht (15) die dielektrische Schicht (4) zumindest teilweise bilden.

8. Verfahren (200) zur Messung von Druck und/oder Feuchtigkeit umfassend zunächst einen ersten Schritt mittels welchem
- zumindest einen Sensor (1) zur Messung von Druck und/oder Feuchtigkeit bereitgestellt wird, wobei der Sensor (1)
- zumindest einen Kondensator (20) mit zumindest zwei Elektroden (10, 11), welche, insbesondere in einer horizontalen Richtung (H1) entlang eines und auf einem, insbesondere flexiblem, Trägermaterial (13) zueinander angeordnet sind, wobei zwischen den Elektroden (10, 11) zumindest eine dielektrische Schicht (4) angeordnet ist,
**dadurch gekennzeichnet, dass**
auf einer dem Trägermaterial (13) abgewandten Seite zumindest einer Elektrode (10, 11) und/oder der dielektrischen Schicht (4) zumindest stellenweise, zumindest eine, zumindest teilweise flüssigkeitsdurchlässige und/oder flüssigkeitsabsorbierende Feuchteschicht (3) angeordnet ist, wobei somit die zumindest eine Elektrode (10, 11) und/oder die dielektrische Schicht (4) in einer Querrichtung (Q1) zwischen dem Trägermaterial (2) und der Feuchteschicht (3) angeordnet sind, sodass sich eine Kapazität durch die auf die dielektrische Schicht (4) zumindest teilweise treffende Flüssigkeit zumindest teilweise verändert, wobei eine Verarbeitungseinheit (4) diese Änderung misst und/oder speichert, sodass ein kapazitiver Feuchtesensor entsteht.
